# EUROPEAN PATENT APPLICATION

(11) **EP 4 832 732 A1**
(43) Date of publication of application: **28.10.2026**
(21) Application number: 26170326.8
(22) Date of filing: 01.04.2026
(51) Int. Cl.: H10P 72/50, H10W 80/00

(54) **BONDING DEVICE, BONDING METHOD, STORAGE MEDIUM, AND MANUFACTURING METHOD FOR ARTICLE**

(30) Priority: 23.04.2025 JP 2025071443
(71) Applicant: Canon Kabushiki Kaisha, Tokyo 146-8501 (JP)
(72) Inventor: FUNABASHI, Naoki, Tokyo, 146-8501 (JP); MORI, Kenichiro, Tokyo, 146-8501 (JP)
(74) Representative: Canon Europe Limited

(57) **Abstract**

A bonding device (BD) for bonding a second object (D) to a first object (W) includes: a first stage (438) configured to hold the first object (W); a second stage (437) configured to support the first stage (438); and a controller (CNT) capable of switching between first control and second control, the first control including performing control to bring the first stage (438) and the second stage (437) into contact with each other, the second control including performing control such that the first stage (438) and the second stage (437) face each other via a gap. The controller is configured to perform the first control when the first object (W) and the second object (D) are in contact with each other.

## Description

### TECHNICAL FIELD

The present disclosure relates to bonding devices, bonding methods, storage media, and manufacturing methods for articles.

### BACKGROUND

Japanese Patent Laid-Open No. 2023-77928 discloses a bonding device for bonding a second object to a first object.

When the second object is to be bonded to the first object, the position of a stage for holding the first object may sometimes become unstable, possibly deteriorating the bonding accuracy unless the position of the stage is stabilized.

### SUMMARY

The present disclosure is directed to a bonding device that is advantageous in terms of bonding accuracy.

The present disclosure in its first aspect provides a bonding device as specified in claim 1. Optional features are specified in claims 2 to 12.
The present disclosure in its second aspect provides a bonding method as specified in claim 13.
The present disclosure in its third aspect provides a non-transitory computer-readable storage medium as specified in claim 14.
The present disclosure in its fourth aspect provides a manufacturing method for an article, as specified in claim 15.
The present disclosure can provide a bonding device that is advantageous in terms of bonding accuracy.

Features of the present disclosure will become apparent from the following description of embodiments with reference to the attached drawings. The following description of embodiments is described by way of example.

### BRIEF DESCRIPTION OF THE DRAWINGS

Fig. 1A and Fig. 1B schematically illustrate a bonding device.
Fig. 2 schematically illustrates a wafer stage.
Fig. 3 schematically illustrates a fine-motion stage.
Fig. 4A and Fig. 4B schematically illustrate a head that holds a die.
Fig. 5 illustrates an example of deforming the die.
Fig. 6A and Fig. 6B illustrate a contact state between a coarse-motion stage and the fine-motion stage according to a first embodiment.
Fig. 7 illustrates a flowchart of a bonding method.
Fig. 8A, Fig. 8B, and Fig. 8C schematically illustrate a fixing mechanism of the fine-motion stage.
Fig. 9 illustrates a flowchart of a bonding method.
Fig. 10 illustrates a flowchart of a manufacturing method for an article.

### DESCRIPTION OF THE EMBODIMENTS

Embodiments of the present disclosure will be described below based on the drawings. The following embodiments do not limit the disclosure according to the scope of the claims. Although multiple features are described in each embodiment, not all of the features are essential to the disclosure. Moreover, the multiple features may be arbitrarily combined. Furthermore, in the appended drawings, identical or similar components are given the same reference signs, and redundant descriptions are omitted.

In the description and the drawings, the directions are indicated by an XYZ coordinate system in which the vertical direction is defined as a Z-axis direction, a horizontal plane perpendicular to the vertical direction is defined as an XY plane, and the respective axes are orthogonal to one another. However, if an XYZ coordinate system is indicated in each drawing, the relevant coordinate system is to be prioritized.

The following description relates to a specific configuration in each of the embodiments.

### First Embodiment

In the following description, a first object is a wafer provided with a semiconductor device, and a second object is a singulated die including a semiconductor device. However, the first object and the second object are not limited to the above, and may be variously modified within the scope of the disclosure.

Examples of the first object include a silicon wafer, a silicon wafer provided with wiring, a glass wafer, a glass panel provided with wiring, a printed wiring board (PWB) provided with wiring, a printed circuit board (PCB) having an electronic component mounted thereon, and a metallic panel. Alternatively, the first object may be a wafer obtained by bonding a die provided with a semiconductor device to a wafer provided with a semiconductor device. As another alternative, the first object may be a die provided with a semiconductor device instead of a wafer provided with a semiconductor device.

Examples of the second object include an individual singulated die, a multilayered object obtained by stacking several singulated dies, and a structural object, such as a fragment of material, an optical element, or a microelectromechanical system (MEMS). A die is singulated by undergoing a dicing process (cutting process).

A bonding technique is not limited to a specific bonding technique. Examples of the bonding technique that may be used include adhesive-based bonding, temporary bonding using a temporary adhesive, bonding by hybrid bonding, atomic diffusion bonding, vacuum bonding, and bump bonding, and any of various temporary bonding techniques or permanent bonding techniques may be employed.

Hybrid bonding is also called direct bonding, and is a bonding method involving directly bonding a bonding object and a bonding target object without interposing a wire, an adhesive, or the like therebetween. An example of hybrid bonding will be simply described. First, the bonding surfaces of the bonding object and the bonding target object are cleaned, and the bonding surfaces are subsequently rendered hydrophilic and activated by, for example, plasma treatment or the like. Then, the activated bonding surfaces of the bonding object and the bonding target object are brought into contact with each other and are temporarily bonded to each other. Subsequently, the bonding object and the bonding target object are permanently bonded to each other by heat treatment or the like. An advantage of hybrid bonding is that electrical characteristics can be improved and performance can be enhanced. For example, the data transmission speed between semiconductor devices can be increased, and the overall device performance can be significantly improved. Another advantage of hybrid bonding is that dies can be stacked, so that space efficiency can be maximized. This makes it possible to manufacture a compact high-performance device.

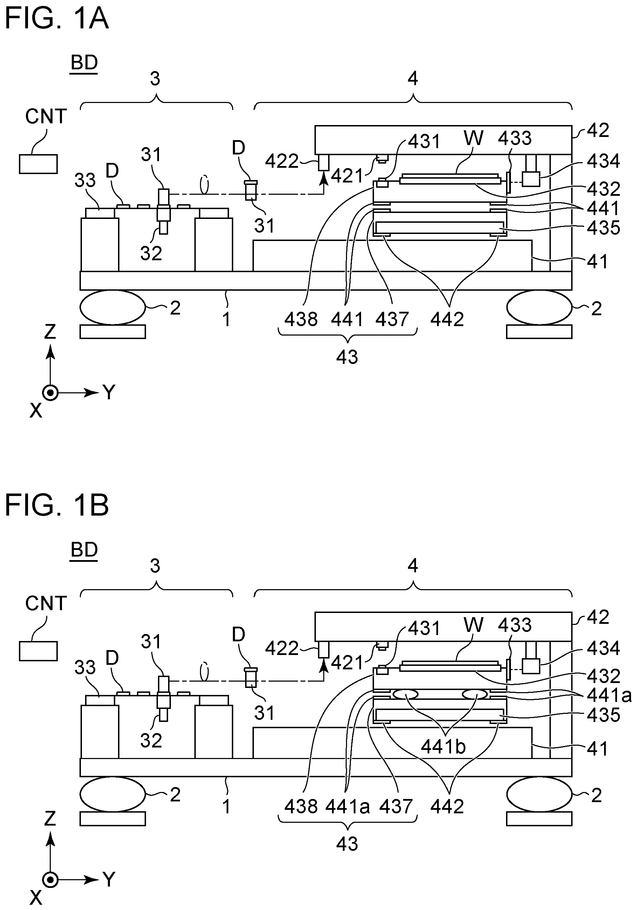

Fig. 1A and Fig. 1B schematically illustrate a bonding device BD. As shown in Fig. 1A, the bonding device BD includes a pickup unit 3 and a bonding unit 4 that are disposed on a base 1 vibration-damped by a mount 2. Although Fig. 1A illustrates an example where the pickup unit 3 and the bonding unit 4 are mounted on a single base 1, the pickup unit 3 and the bonding unit 4 may be mounted individually on different bases. The bonding device BD is configured to position a die D serving as a second object at a bonding target location on a wafer W serving as a first object and bond the die D to the wafer W. The die D is provided in a state where it is held by dicing tape bonded to a dicing frame 33. Instead of being held by dicing tape, the die D may be held by a glass carrier or the like.

The bonding device BD further includes a controller CNT that controls the pickup unit 3 and the bonding unit 4. The controller CNT is constituted of a programmable logic device (PLD), such as a field-programmable gate array (FPGA), an application-specific integrated circuit (ASIC), a general-purpose or dedicated computer having a program incorporated therein, or a combination of all or one or more of the above.

The pickup unit 3 includes a pickup head 31 and a release head 32. The pickup unit 3 uses the release head 32 to release the die D to be bonded to the wafer W from the dicing tape, and uses the pickup head 31 to hold this die D. For example, the pickup head 31 rotates the die D by 180° around a Y axis, and transfers the die D to a bonding head 422 of the bonding unit 4.

The pickup head 31 comes into contact with the bonding surface of the die D. In an example applied to a bonding method that involves performing bonding by activating the surfaces as in hybrid bonding or the like, the pickup head 31 is preferably set to have a highly stable surface. A highly stable surface is obtained by, for example, applying a diamond-like carbon (DLC) coating or a fluorine coating to the surface of the pickup head 31 that comes into contact with the bonding surface of the die D. With this coating, an interaction is less likely to occur between the surface of the die D and the surface of the pickup head 31. Alternatively, in the example applied to the bonding method that involves performing bonding by activating the surfaces as in hybrid bonding or the like, it is desirable to reduce the contact area by employing a shape with a small contact area, such as a high-density pin shape. As another alternative, in the example applied to the bonding method that involves performing bonding by activating the surfaces as in hybrid bonding or the like, it is preferable that the pickup head 31 is held by a non-contact handling method that utilizes a Bernoulli chuck or an ultrasonic squeeze effect. As a further alternative, in the example applied to the bonding method that involves performing bonding by activating the surfaces as in hybrid bonding or the like, it is conceivable that the pickup head 31 does not come into contact with the bonding surface of the die D by holding a side surface or an edge of the die D.

The bonding unit 4 includes a platen 41 and a supporter 42. A wafer stage 43 serving as a first holder is mounted on the platen 41. The wafer stage 43 includes a coarse-motion stage (second stage) 437 and a fine-motion stage (first stage) 438. The fine-motion stage 438 is supported by the coarse-motion stage 437 directly, indirectly, or via a gap.

The coarse-motion stage 437 includes a driving mechanism 435 and is driven over a wider range than the fine-motion stage 438. The driving mechanism 435 includes a mechanism such as a linear motor, and drives (moves) the coarse-motion stage 437 in an X-axis direction (first direction) and a Y-axis direction (second direction). The fine-motion stage 438 supported by the coarse-motion stage 437 moves in the X-axis direction (first direction) and the Y-axis direction (second direction) in accordance with movement of the coarse-motion stage 437. The driving mechanism 435 may also be configured to drive the wafer stage 43 to rotate it around an axis parallel to a Z-axis direction (third direction). As an alternative to the driving mechanism 435 driving the wafer stage 43 to rotate it around the axis parallel to the Z-axis direction, the bonding head 422 may drive the die D to rotate it around the axis parallel to the Z-axis direction. The driving mechanism 435 is a positioning mechanism that changes the relative position between a wafer chuck 432 (or the wafer W) serving as a first holder and the bonding head 422 (or the die D) serving as a second holder. The fine-motion stage 438 is provided with a die measuring unit 431, a bar mirror 433, the wafer chuck 432, and a reference plate 436, and achieves high-precision positioning. The die measuring unit 431 is, for example, an imager (camera) that detects (captures) the position of a characteristic point of the die D serving as the second object held by the bonding head 422. The bar mirror 433 is used as a target of an interferometer 434. The wafer chuck 432 holds the wafer W serving as the first object.

The coarse-motion stage 437 is set to float above the platen 41 by using an air bearing 442 or the like. Accordingly, vibration transmitted from the platen 41 to the wafer stage 43 can be reduced. The coarse-motion stage 437 further includes a permanent magnet (not shown). This permanent magnet is used for generating a force that attracts the coarse-motion stage 437 to the platen 41. Accordingly, the coarse-motion stage 437 uses the air bearing 442 to receive a force in the +Z direction, and uses the permanent magnet to receive a force in the -Z direction. Thus, even when the coarse-motion stage 437 receives a bonding load applied when the die D and the wafer W are being bonded to each other, the coarse-motion stage 437 can withstand the bonding load to sufficiently and stably maintain its position.

An adjustment mechanism 441 capable of adjusting the distance between the coarse-motion stage 437 and the fine-motion stage 438 is disposed between the coarse-motion stage 437 and the fine-motion stage 438. For example, the adjustment mechanism 441 is provided with actuators each including an electromagnet, as shown in Fig. 1A. The actuators are provided to form a pair at the coarse-motion-stage-437-side surface of the fine-motion stage 438 and the fine-motion-stage-438-side surface of the coarse-motion stage 437. In detail, one of the surfaces is provided with a coil, whereas the other surface is provided with a magnet. This electromagnetic-actuator-type adjustment mechanism 441 is combined with the fine-motion stage 438 or the coarse-motion stage 437 and is included in the fine-motion stage 438 or the coarse-motion stage 437. As an example, the coarse-motion-stage-437-side surface of the fine-motion stage 438 may be provided with the magnet, and the fine-motion-stage-438-side surface of the coarse-motion stage 437 may be provided with the coil. In this case, the fine-motion stage 438 includes the magnet, and the coarse-motion stage 437 includes the coil. By applying an electric current to the coil, a force (i.e., a force that causes the fine-motion stage 438 to float relative to the coarse-motion stage 437) is generated, so that the coarse-motion stage 437 supports the fine-motion stage 438 via a gap. In other words, the coarse-motion stage 437 and the fine-motion stage 438 are not in contact with each other. Alternatively, the coarse-motion-stage-437-side surface of the fine-motion stage 438 may be provided with the coil, and the fine-motion-stage-438-side surface of the coarse-motion stage 437 may be provided with the magnet.

The adjustment mechanism 441 includes, for example, multiple adjustment mechanisms 441 provided at multiple locations in the XY plane. By being individually or simultaneously driven, these adjustment mechanisms 441 adjust the position of the fine-motion stage 438 to a desired position (orientation). In the case where the adjustment mechanisms 441 are provided at multiple locations (e.g., three or more locations), a position (Z) of the fine-motion stage 438 in the Z-axis direction, a rotational angle (ωZ) around the Z axis, a rotational angle (ωX) around the X axis, and a rotational angle (ωY) around the Y axis are adjustable. The controller CNT controls the adjustment mechanisms 441 to control the position of the fine-motion stage 438 to a desired position (orientation). The adjustment mechanisms 441 are provided at multiple locations between the coarse-motion stage 437 and the fine-motion stage 438 and, for example, adjust the distance between the coarse-motion stage 437 and the fine-motion stage 438 at the respective locations, thereby adjusting the Z position, the ωZ position, the ωX position, and the ωY position.

Each adjustment mechanism 441 does not have to be an electromagnetic actuator as mentioned above, and may be, for example, a mechanism whose volume varies in response to fluctuations in internal air pressure, or an air bearing mechanism that adjusts the distance between the coarse-motion stage 437 and the fine-motion stage 438 by a force of ejected air. A mechanism whose volume varies in response to fluctuations in air pressure is, for example, a balloon-like mechanism that adjusts the air pressure within a shape-variable container by using a pump or the like to change the shape of the container. In the case of this mechanism, when the distance between the coarse-motion stage 437 and the fine-motion stage 438 is to be increased, the air pressure is increased (i.e., is adjusted toward the positive side) to inflate the container. The mechanism whose volume varies in response to fluctuations in air pressure is not included in the coarse-motion stage 437 or the fine-motion stage 438. In the case of the air bearing mechanism that adjusts the distance between the coarse-motion stage 437 and the fine-motion stage 438 by a force of ejected air, the pressure of ejected air is increased when the distance between the coarse-motion stage 437 and the fine-motion stage 438 is to be increased. In other words, the pressure in the space between the coarse-motion stage 437 and the fine-motion stage 438 is adjusted toward the positive side. In the case of the air bearing mechanism, each adjustment mechanism 441 is included in (e.g., combined with) at least one of the coarse-motion stage 437 and the fine-motion stage 438.

The adjustment mechanisms 441 may be a combination of multiple adjustment mechanisms, as shown in Fig. 1B. Fig. 1B is an example where two types of adjustment mechanisms are combined, the two types being an electromagnetic actuator 441a and a mechanism 441b whose volume varies in response to fluctuations in air pressure. In the case of such a combination, the adjustment of the distance between the coarse-motion stage 437 and the fine-motion stage 438 is actively performed by both mechanisms, so that a desired distance can be set within a short period of time. If the distance is to be maintained constant, it is possible to maintain the distance by simply using the mechanism 441b whose volume varies in response to fluctuations in air pressure without applying an electric current to the electromagnetic actuator 441a. Accordingly, the electric power required for operating the electromagnetic actuator 441a (linear motor) and the amount of heat generated due to the operation of the electromagnetic actuator 441a can be reduced. The adjustment mechanisms are not limited to the above examples, and other mechanisms may be employed so long as the distance between the coarse-motion stage 437 and the fine-motion stage 438 can be adjusted. Moreover, the combination of multiple adjustment mechanisms is not limited to the combination of two types and may be a combination of three or more types, and the types employed are not particularly limited.

The supporter 42 has a wafer measuring unit 421 disposed thereon. The wafer measuring unit 421 is, for example, an imager (camera). The wafer measuring unit 421 detects (captures) the position of a characteristic point of the wafer W serving as the first object held by the wafer chuck 432.

The controller CNT is configured to identify or calculate the positions of multiple bonding target locations on the wafer W based on the position of the characteristic point of the wafer W detected by using the wafer measuring unit 421. The supporter 42 further has the interferometer 434 disposed thereon for measuring the position of the wafer stage 43 by using the bar mirror 433. The supporter 42 further has the bonding head 422 mounted thereon for receiving and holding the die D serving as the second object transferred from the pickup head 31 and for bonding the die D to one of the bonding target locations of the wafer W. The bonding head 422 also functions as a second holder that holds the die D serving as the second object. The supporter 42 functions as a supporter that supports the bonding head 422, serving as the second holder, and the wafer measuring unit 421.

When the die D serving as the second object is to be bonded to the bonding target location of the wafer W serving as the first object, the bonding head 422 drives the die D in the negative direction (downward) of the Z axis to bond the die D to the bonding target location of the wafer W. Alternatively, the driving mechanism 435 drives the wafer stage 43 in the positive direction (upward) of the Z axis to bond the die D to the bonding target location of the wafer W. As another alternative, the wafer chuck 432 is driven in the positive direction (upward) of the Z axis by a driving mechanism (not shown), so that the die D is bonded to the bonding target location of the wafer W. Of these driving mechanisms, two or more driving mechanisms may operate simultaneously to adjust the relative position between the die D and the wafer W.

In the above description, the pickup head 31 rotates the die D by 180° and transfers the die D to the bonding head 422. Alternatively, a first die holder and a second die holder may be provided. In this case, the pickup head 31 may transfer the die D to the first die holder, the first die holder may transfer the die D to the second die holder, and the second die holder may transfer the die D to the bonding head 422. As another alternative, a driving mechanism that drives the bonding head 422 may be provided, and the bonding head 422 may move such that the bonding head 422 can hold the die D. As a further alternative, the pickup head 31 may place the die D on a relay base provided at the wafer stage 43, and the die D on the relay base may be held by the bonding head 422 by using a driving mechanism included in the wafer stage 43 or by driving the bonding head 422. In this case, the position of the characteristic point of the die D may be detected when the die D is placed on the relay base.

In order to improve productivity, multiple pickup units, multiple pickup heads, multiple release heads, and/or multiple bonding heads may be provided. These heads are individually controllable in terms of driving. For example, the drive timing and the drive amount of each of the multiple bonding heads may be individually adjusted.

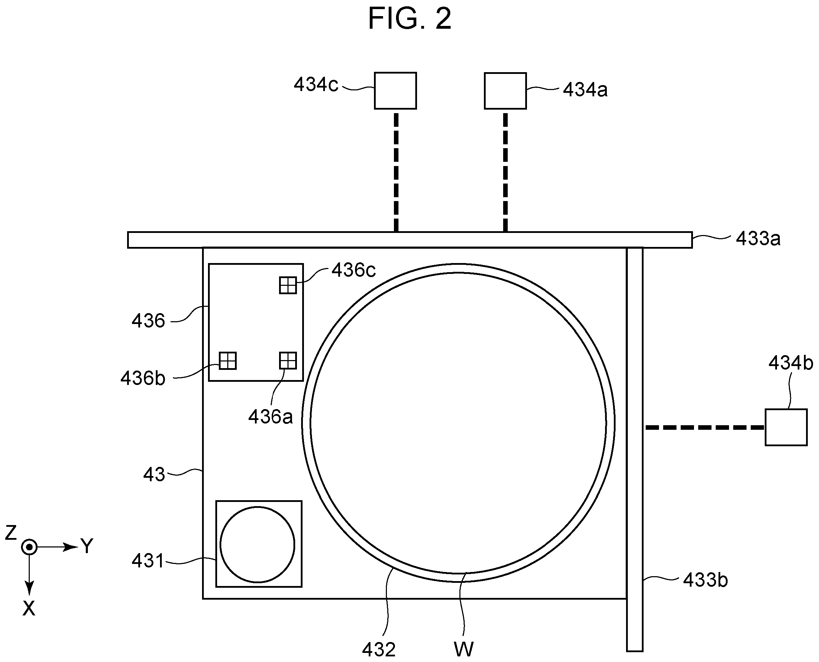

Fig. 2 schematically illustrates the wafer stage 43. The wafer W is held by the wafer chuck 432. The wafer W or the wafer stage 43 is positioned in the X-axis direction (first direction) and the Y-axis direction (second direction), which are orthogonal to each other or intersect each other, and with respect to rotation around an axis parallel to the Z-axis direction (third direction) orthogonal to the above directions. In order to achieve this, the wafer stage 43 is provided with the bar mirror 433, more specifically, bar mirrors 433a and 433b. The bar mirror 433a functions as a target for interferometers 434a and 434c. The controller CNT can detect the position of the wafer stage 43 in the X-axis direction based on an output from the interferometer 434a, and can detect rotation of the wafer stage 43 around the axis parallel to the Z-axis direction based on outputs from the interferometers 434a and 434c. The bar mirror 433b functions as a target for an interferometer 434b. The controller CNT can detect the position of the wafer stage 43 in the Y-axis direction based on an output from the interferometer 434b. The controller CNT is configured to feedback-control the position of the wafer W or the wafer stage 43 in the X-axis direction and the Y-axis direction and with respect to the rotation around the axis parallel to the Z-axis direction orthogonal to these directions based on the outputs from the interferometers 434a, 434b, and 434c. Furthermore, the interferometer 434 may include interferometers (not shown) at different heights in the Z-axis direction. Based on measurement results of these interferometers at different heights in the Z-axis direction, information about rotation around an axis parallel to the X-axis direction or the Y-axis direction can be acquired. The interferometer 434 and the controller CNT may be conceived as components of the aforementioned positioning mechanism.

The upper surface of the wafer stage 43 is provided with the reference plate 436. The reference plate 436 has multiple marks 436a, 436b, 436c disposed thereon. The reference plate 436 is composed of a material with a low thermal expansion coefficient, and the marks are rendered thereon with high positional accuracy. In one example, the reference plate 436 is formed by rendering the marks on a quartz substrate by using a semiconductor lithography rendering technique. The reference plate 436 has a surface at a height substantially equal to that of the surface of the wafer W, and is observed with the wafer measuring unit 421. Alternatively, a camera for observing the reference plate 436 may be additionally provided.

The following description relates to a method for ensuring an origin position, magnification, directions (rotations) of the X axis and the Y axis, and orthogonality of the wafer stage 43 by using the reference plate 436. The mark 436a is observed with the wafer measuring unit 421, and an output value from the interferometer when the mark 436a is positioned at the center of an output image from the wafer measuring unit 421 is set as the origin point of the wafer stage 43. Then, the mark 436b is observed with the wafer measuring unit 421, and the direction (rotation) of the Y axis of the wafer stage 43 and the magnitude in the Y-axis direction are determined based on an output value from the interferometer when the mark 436b is positioned at the center of the output image from the wafer measuring unit 421. Subsequently, the mark 436c is observed with the wafer measuring unit 421, and the direction (rotation) of the X axis of the wafer stage 43 and the magnitude in the X-axis direction are determined based on an output value from the interferometer when the mark 436c is positioned at the center of the output image from the wafer measuring unit 421. Accordingly, with the direction from the mark 436b to the mark 436a of the reference plate 436 being defined as the Y axis of the bonding device BD and the direction from the mark 436c to the mark 436a being defined as the X axis of the bonding device BD, calibration of the directions of the axes and the orthogonality can be performed. Furthermore, calibration can be performed by using the distance between the mark 436b and the mark 436a as a Y-axis scale reference of the bonding device BD and the distance between the mark 436c and the mark 436a as an X-axis scale reference of the bonding device BD. In an interferometer, the refractive index of an optical path changes due to atmospheric pressure fluctuations and temperature fluctuations, thereby causing a measurement value to vary. Therefore, it is desirable to perform calibration at an arbitrary timing to ensure the origin position, magnification, rotation, and orthogonality of the wafer stage 43. In order to reduce variations in the measurement value of the interferometer, it is desirable to cover the space in which the wafer stage 43 is disposed with a temperature-adjusted chamber and to control the temperature within the temperature-adjusted chamber.

Although the example described above involves performing calibration using a reference plate, the calibration method is not limited to this example. For example, calibration may be performed by a butting operation against a reference surface, or high-accuracy positioning may be performed by using a position measuring device whose absolute value is ensured, such as a white-light interferometer.

The position of the wafer stage 43 may be measured by using an encoder. In detail, an encoder scale and an encoder head may be disposed in place of an interferometer and a bar mirror. The encoder scale is preferably composed of a material with a low thermal expansion coefficient. In one example, the encoder scale is formed by rendering a scale on a quartz substrate by using a semiconductor lithography rendering technique. Furthermore, multiple encoder heads may be disposed, and, for example, the multiple encoder heads may be used in a switching fashion in accordance with the position of the bonding target location. Alternatively, a pair of encoder heads may be disposed symmetrically with respect to the bonding target location. This configuration is advantageous for improving position measurement accuracy.

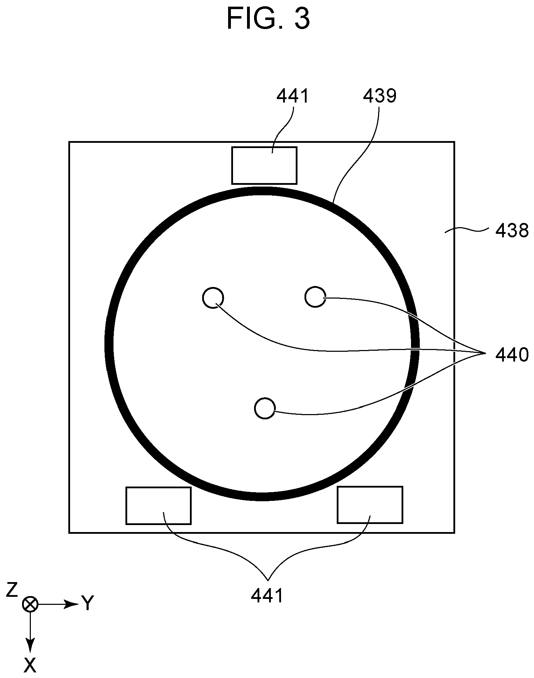

Fig. 3 schematically illustrates the fine-motion stage 438 and corresponds to a case where the fine-motion stage 438 is viewed from the -Z side between the fine-motion stage 438 and the coarse-motion stage 437. In the example in Fig. 3, the adjustment mechanisms 441 are disposed at three different locations on the fine-motion stage 438. The fine-motion stage 438 further has a fine-motion air bearing 439 and a θ linear motor (ωZ linear motor) (not shown), and is adjustable in terms of the rotational angle around the Z axis. The fine-motion stage 438 is also provided with through-holes 440 for receiving lift pins that hold the wafer W when the wafer W is to be supported by the wafer chuck 432 or when the wafer W is to be unloaded from the wafer chuck 432. In the example in Fig. 3, three lift pins are to be inserted, so that three through-holes 440 are provided. As an alternative to the example in Fig. 3 in which the adjustment mechanisms 441 are provided at three different locations, the adjustment mechanisms 441 may be provided at two different locations or at three or more different locations.

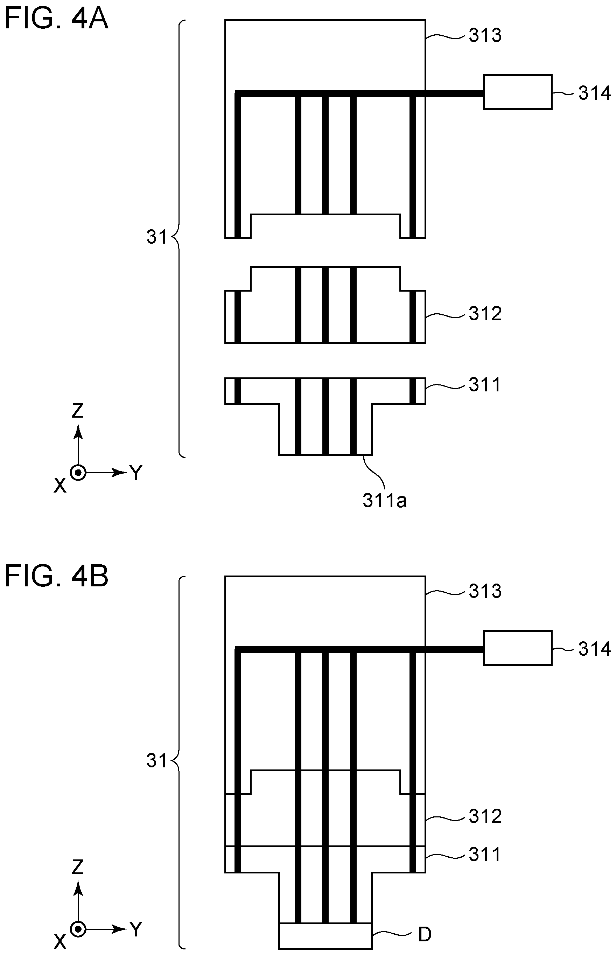

Fig. 4A and Fig. 4B schematically illustrate a head that holds the die D. Although the pickup head 31 is illustrated as an example in Fig. 4A and Fig. 4B, a similar configuration may be employed with respect to the bonding head 422. The head that holds the die D includes a collet holder 312 that holds a collet 311, and a main body 313 that holds the collet holder 312. The collet holder 312 holds the collet 311 serving as a tool that comes into contact with the die D. Fig. 4A illustrates a state where the collet 311, the collet holder 312, and the main body 313 are not combined. Fig. 4B illustrates a state where the collet 311, the collet holder 312, and the main body 313 are combined. When a bonding process is to be performed, the collet 311, the collet holder 312, and the main body 313 are in the combined state as shown in Fig. 4B.

For example, the collet holder 312 is held by the main body 313 and the collet 311 is held by the collet holder 312 as a result of a vacuum source 314 suctioning gas from a space between a holding object and an object to be held. Alternatively, the holding of the collet holder 312 and the holding of the collet 311 by the collet holder 312 may be achieved mechanically by using mechanisms, such as claws, or by magnetic force using magnets.

The collet 311 uses its holding surface 311a to hold the die D. The material of the collet 311 is, for example, fluorine-containing rubber, polyether ether ketone (PEEK), or stainless steel (SUS). For example, the die D is held by the collet 311 as a result of gas being suctioned from a space between the holding surface 311a and the die D.

The collet holder 312 is constantly held by the main body 313. On the other hand, the collet 311 may sometimes be replaced depending on the type of die D. The collet 311 may also be replaced in accordance with damage (wear) or contamination occurring when multiple dies D are to be bonded together.

For example, when the collet 311 is to be replaced in accordance with damage or contamination, the used collet is discarded into a collet disposal section (not shown), and a new collet supplied from a collet supply section (not shown) is attached to the collet holder 312. The detachment and attachment of the collet 311 in this case are performed by, for example, a collet replacement hand (not shown). The collet 311 may be washed, as appropriate, and the bonding device BD may include a unit for washing the collet.

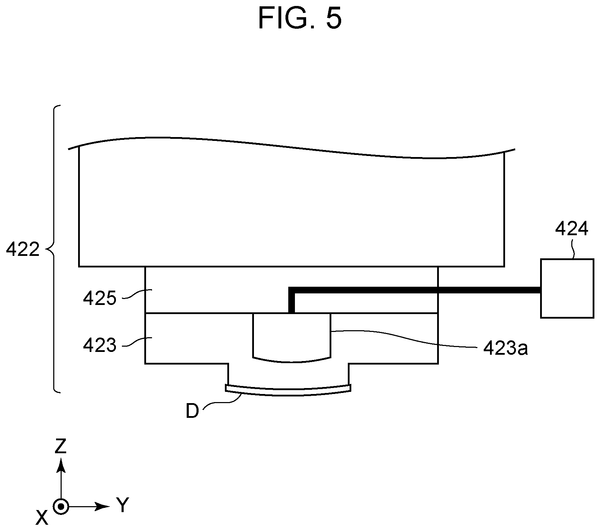

Fig. 5 illustrates an example of deforming the die D. When the die D is to be bonded to the wafer W, it is preferable that the occurrence of a void due to air entering the space between the wafer W and the die D is reduced. Hence, the die D is deformed such that the bonding surface of the die D is convexed, and the contact area between the die D and the wafer W is gradually increased so that the die D and the wafer W entirely come into contact with each other after the die D and the wafer W are partially brought into contact with each other. In detail, after the die D and the wafer W are partially brought into contact with each other, the amount of convexity (i.e., warpage amount or curvature amount) of the die D is gradually increased. When the die D is deformed such that the central region of the die D is convexed downward, the central region of the die D first comes into contact with the wafer W. Then, the contact area between the die D and the wafer W gradually increases. In this increase of the contact area, the amount of deformation of the die D may be controlled by controlling a mechanism for deforming the die D, or the amount of deformation of the die D may be controlled based on a bonding load (bonding pressure) applied by a mechanism that decreases the distance between the die D and the wafer W. In the example in Fig. 5, a collet 423 is held by a collet holder 425 included in the bonding head 422. A pressurization source 424 supplies air into a space (cavity) 423a provided in the collet 423 so as to deform the collet 423, and the die D held by the collet 423 becomes deformed in accordance with the deformation of the collet 423. The mechanism for deforming the die D is not limited to this example. For example, a pin or a spring may be used to apply a force to the collet or the die D to deform the die D.

When the die D and the wafer W are to be bonded to each other, a bonding load (bonding pressure) is applied to press the die D against the wafer W (or to press the wafer W against the die D). In this case, for example, the force ranges between 0.1 N and 100 N, or between 0.1 N and 50 N. When the adjustment mechanisms 441 are adjusting the distance between the coarse-motion stage 437 and the fine-motion stage 438 so as not to bring them into contact with each other, the rotational angle (ωX position, ωY position, ωZ position) of the fine-motion stage 438 can be adjusted. On the other hand, in the state where the adjustment mechanisms 441 are adjusting the distance between the coarse-motion stage 437 and the fine-motion stage 438 so as not to bring them into contact with each other, when the bonding load is applied, the force of the adjustment mechanisms 441 cannot withstand the bonding load, making it difficult to stably maintain the position of the fine-motion stage 438. In particular, when a bonding process is to be performed on an end of the wafer W, there is a higher possibility that the position of the fine-motion stage 438 cannot be maintained than when a bonding process is to be performed on a central region of the wafer W. If the position of the fine-motion stage 438 is not stable during the bonding between the wafer W and the die D, the relative position between the wafer W and the die D becomes deviated from a desired relative position, thus decreasing the alignment accuracy in bonding.

In view of this, the bonding device BD according to this embodiment switches between first control involving performing control to bring the coarse-motion stage 437 and the fine-motion stage 438 into contact with each other and second control involving performing control not to bring the coarse-motion stage 437 and the fine-motion stage 438 into contact with each other. The first control is to be performed when the wafer W (first object) and the die D (second object) are in contact with each other.

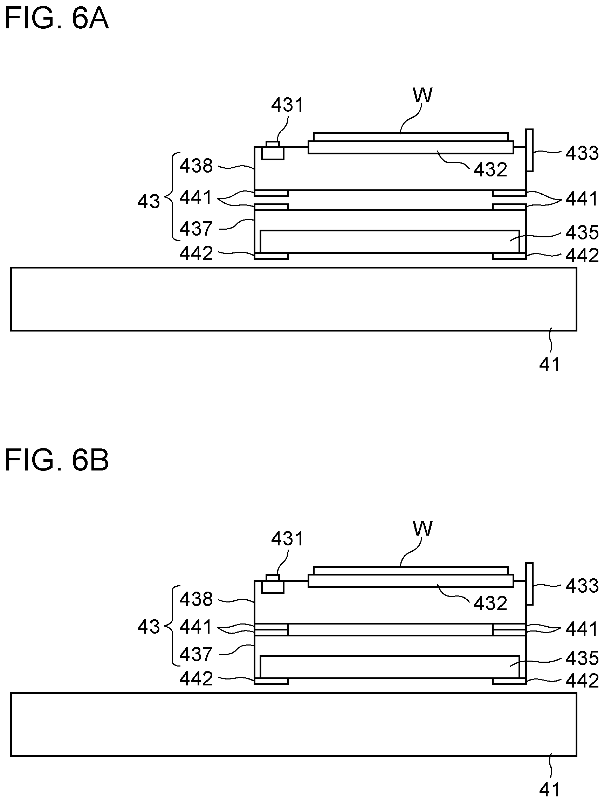

Fig. 6A and Fig. 6B illustrate a contact state between the coarse-motion stage 437 and the fine-motion stage 438 according to this embodiment. For example, during alignment of the wafer W (i.e., during positional adjustment of the fine-motion stage 438), the rotational angle (ωZ position) around the Z axis needs to be adjusted by rotating the fine-motion stage 438. Thus, as shown in Fig. 6A, control (second control) is performed so as not to bring the coarse-motion stage 437 and the fine-motion stage 438 into contact with each other. On the other hand, since the position of the fine-motion stage 438 is not stable due to a bonding load applied during bonding (contact) between the wafer W and the die D, control (first control) is performed to bring the coarse-motion stage 437 and the fine-motion stage 438 into contact with each other, as shown in Fig. 6B. In the first control, the adjustment mechanism 441 (e.g., a magnet) included in the fine-motion stage 438 and the adjustment mechanism 441 (e.g., a coil) included in the coarse-motion stage 437 are in contact with each other. The controller CNT can switch between the first control and the second control. In the first control, the adjustment mechanisms 441 are controlled such that the adjustment mechanisms 441 do not form a gap between the coarse-motion stage 437 and the fine-motion stage 438. For example, if each adjustment mechanism 441 is an electromagnetic actuator, control is performed to prevent an electric current from flowing thereto (i.e., to stop the supply of an electric current). If each adjustment mechanism 441 is a mechanism whose volume varies in response to fluctuations in air pressure, the air pressure is reduced (i.e., is set substantially equal to the atmospheric pressure or to negative pressure). If each adjustment mechanism 441 is an air bearing mechanism that adjusts the distance between the coarse-motion stage 437 and the fine-motion stage 438 by a force of ejected air, control is performed to stop the ejection of gas. Accordingly, the adjustment mechanisms 441 are controlled to bring the coarse-motion stage 437 and the fine-motion stage 438 into contact with each other.

For example, the position of the fine-motion stage 438 in Fig. 6B is shifted in the Z-axis direction by -0.1 mm to -10 mm, more preferably, by -0.5 mm to -5 mm, relative to the position of the fine-motion stage 438 in Fig. 6A. In other words, the fine-motion stage 438 and the coarse-motion stage 437 in the second control face each other in the Z-axis direction via a gap ranging between 0.1 mm and 10 mm, more preferably, a gap ranging between 0.5 mm and 5 mm.

Accordingly, control is performed to bring the coarse-motion stage 437 and the fine-motion stage 438 into contact with each other during bonding (contact) between the wafer W and the die D, so that the bonding can be performed in a state where the position of the fine-motion stage 438 is stable. Particularly, control is performed to bring the coarse-motion stage 437 and the fine-motion stage 438 into contact with each other while a bonding load is applied during bonding between the wafer W and the die D.

In this embodiment, in the case of the second control, the position of the fine-motion stage 438 is adjustable with respect to six axes (X, Y, Z, ωX, ωY, and ωZ axes). On the other hand, in the case of the first control, since the coarse-motion stage 437 and the fine-motion stage 438 are in contact with each other, the position of the fine-motion stage 438 alone is not adjustable. The fine-motion stage 438 can be positionally adjusted by adjusting the position of the coarse-motion stage 437. In the case of this embodiment, since the coarse-motion stage 437 is movable in the X-axis direction and the Y-axis direction, the position of the fine-motion stage 438 is adjustable with respect to two axes (X and Y axes) in the first control.

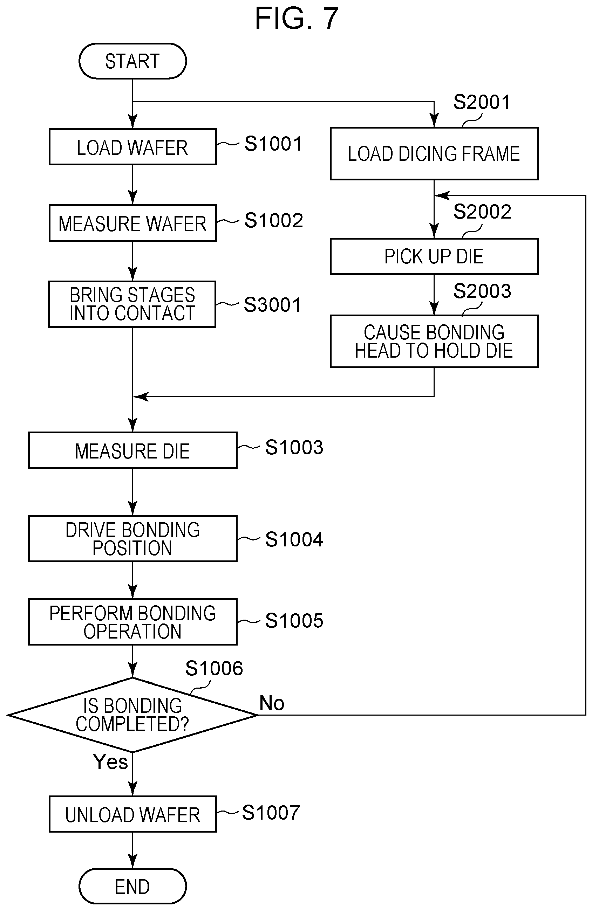

Fig. 7 illustrates a flowchart of a bonding method according to this embodiment. This bonding method is controlled by the controller CNT. In step S1001, the wafer W serving as the first object is loaded into the bonding device BD and is held by the wafer chuck 432 (first holding step). Since foreign matter adhered to a bonding surface leads to a bonding defect, the interior of the bonding device BD may be a space having high cleanliness of, for example, about Class 1. In order to maintain high cleanliness, the wafer W is also accommodated in a highly sealed container in which high cleanliness is maintained, such as a front-opening unified pod (FOUP), and is loaded into the bonding device BD from the container. Furthermore, in order to enhance cleanliness, the wafer W may be washed inside the bonding device BD after the wafer W is loaded therein. Pretreatment is also performed for bonding. Examples of the pretreatment include washing (cleaning) of the wafer W and the die D, application of an adhesive to the wafer W in the case of adhesive-based bonding, and activation of the surface of the wafer W in the case of hybrid bonding. The wafer W is roughly positioned by a pre-aligner (not shown) based on a notch or an orientation flat and an outer peripheral position of the wafer, is transported to the wafer chuck 432 serving as the first holder on the wafer stage 43, and is held by the wafer chuck 432.

In step S1002, the position of a characteristic point (measurement target location) of the wafer W is measured by using the wafer measuring unit 421, and the position of a bonding target location is determined based on the measured position. The positional relationship (relative position) between the position of the characteristic point (measurement target location) of the wafer W and the bonding target location is already known. A focus adjustment for capturing an image of the characteristic point of the wafer W by using the wafer measuring unit 421 is achieved by providing a focus adjustment mechanism within the wafer measuring unit 421.

Alternatively, the focus adjustment may be achieved by providing the wafer stage 43 with a Z-axis driving mechanism and causing the Z-axis driving mechanism to drive the wafer W with respect to the Z axis. Although the wafer W is often provided with an alignment mark for alignment, the characteristic point that enables position identification is measured if the wafer W is not provided with an alignment mark. The controller CNT causes the wafer measuring unit 421 to capture an image of the characteristic point of the wafer W (first imaging step), and can detect, as the position of the characteristic point (measurement target location), the relative position of the image of the characteristic point relative to the center of the output image from the wafer measuring unit 421.

In order to measure the relative position of the mark relative to a reference point of the bonding device BD with high accuracy, an offset amount may be determined in advance. This includes a process involving driving the wafer stage 43 such that a mark on the reference plate 436 is within the visual field of the wafer measuring unit 421, and measuring the position of the mark by using the wafer measuring unit 421. The offset amount relative to the position measured by using the wafer measuring unit 421 can be determined based on the driving position of the wafer stage 43 and the position of the mark measured by using the wafer measuring unit 421. The reference point of the bonding device BD is normally set as a specific mark position of the reference plate 436, but may be another location so long as the location serves as a reference position.

Since the measurement range of an interferometer or an encoder in the rotational direction is small, the amount of rotation that can be corrected by the wafer stage 43 is small. Therefore, if the amount of rotation of the wafer W is large, it is desirable to correct the rotation and re-hold the wafer W. If the wafer W is re-held, it is necessary to measure the position of the wafer W again. In the process of this operation, the surface position of the bonding surface of the wafer W may be measured during an autofocus operation performed in mark measurement on the wafer, or by using a first height measuring device (not shown). Since the thickness of the wafer W varies, it is advantageous to measure the surface position of the wafer W in order to manage the gap between the wafer W and the die D with high accuracy during a bonding operation.

Since the origin position, magnification, directions (rotations) of the X axis and the Y axis, and orthogonality of the wafer stage 43 are ensured by using the reference plate 436, the position of the characteristic point (measurement target location) of the wafer W is measured with reference to the origin position of the wafer stage 43, the X axis, and the Y axis. The wafer W has bonding target locations (or semiconductor devices serving as bonding targets) at a fixed pitch.

Because these bonding target locations (semiconductor devices) are formed such that multiple layers are positioned with high accuracy by a semiconductor manufacturing apparatus, the bonding target locations (semiconductor devices) are normally arranged repeatedly at a pitch having nanometer-level accuracy. Therefore, in the wafer alignment in step S1002, it is not necessary to measure the positions of characteristic points respectively corresponding to all of the bonding target locations (semiconductor devices). In view of this, the controller CNT measures the positions of measurement target locations smaller in number than the number of bonding target locations, and statistically processes the measurement results, so as to execute a process for determining the positions of multiple bonding target locations (first measuring step). In this case, the multiple measurement target locations can be determined based on arrangement information of the semiconductor devices. In order to determine the positions of multiple bonding target locations, the controller CNT calculates, based on measurement results of the positions of multiple measurement target locations, an origin position of a repeated arrangement of the multiple bonding target locations, rotational amounts in the X-axis and Y-axis directions and orthogonality thereof, and a magnification error of a repetition pitch.

The wafer chuck 432 desirably has a temperature adjustment function for adjusting the temperature of the wafer W. Alternatively, the temperature of the wafer chuck 432 may be adjusted by a temperature adjustment mechanism (not shown), and the temperature-adjusted wafer chuck 432 may be transported to the wafer stage 43. This is because, in a case where the thermal expansion coefficient of a silicon wafer is 3 ppm/°C and the wafer has a diameter of 300 mm, the outermost periphery thereof positionally moves by 450 nm = 0.00045 mm = 150 mm × 0.000003 when the temperature increases by 1°C. If the bonding position moves after the wafer alignment, the bonding cannot be performed with high positional accuracy. Therefore, it is desirable to stabilize the temperature of the wafer with an accuracy of 0.1°C or less.

If the first object is an interposer provided with wiring, the multiple bonding target locations are set not based on an array of semiconductor devices but an array of repeatedly-formed wires.

If the first object is a wafer or panel not having a pattern, the wafer alignment in step S1002 is not performed.

In step S1002, the rotational angle (ωZ) of the wafer W (fine-motion stage 438) around the Z axis is also adjusted. In other words, in step S1002, the rotational angle of the wafer W around the axis (Z axis) orthogonal to the surface (XY plane) of the wafer W having the bonding target region is adjusted.

Subsequently, in this embodiment, control (first control) is performed in step S3001 to bring the coarse-motion stage 437 and the fine-motion stage 438 into contact with each other. This contact state is at least maintained until a bonding operation in step S1005. When the coarse-motion stage 437 and the fine-motion stage 438 are brought into contact with each other, if the controller CNT determines that the position of the fine-motion stage 438 has deviated based on a measurement value of an interferometer or the like, the controller CNT performs the second control. In detail, the adjustment mechanisms 441 are actuated to set the coarse-motion stage 437 and the fine-motion stage 438 in a non-contact state. Then, the controller CNT adjusts the relative position between the coarse-motion stage 437 and the fine-motion stage 438, and subsequently performs the first control again to bring the coarse-motion stage 437 and the fine-motion stage 438 into contact with each other.

The following description relates to an example where the adjustment mechanisms 441 are a combination of an electromagnetic actuator and a mechanism whose volume varies in response to fluctuations in air pressure. In step S3001, the mechanism whose volume varies in response to fluctuations in air pressure is controlled to a state where there is no effect on the distance between the coarse-motion stage 437 and the fine-motion stage 438 (i.e., the air pressure is set substantially equal to the atmospheric pressure or to negative pressure). At this stage, the coarse-motion stage 437 and the fine-motion stage 438 are not in contact with each other due to a force from the electromagnetic actuator. Subsequently, an electric current is prevented from flowing to the electromagnetic actuator, and the coarse-motion stage 437 and the fine-motion stage 438 are brought into contact with each other. Then, if the controller CNT determines that the position of the fine-motion stage 438 has deviated based on a measurement value of the interferometer or the like, the controller CNT actuates the electromagnetic actuator to bring the coarse-motion stage 437 and the fine-motion stage 438 into contact with each other. After the relative position between the coarse-motion stage 437 and the fine-motion stage 438 is adjusted, the coarse-motion stage 437 and the fine-motion stage 438 are brought into contact with each other again. In this embodiment, step S3001 is performed after the position of the wafer W is measured and the rotational angle of the wafer W (fine-motion stage 438) around the Z axis is adjusted in step S1002. However, if it is already known that the adjustment of the rotational angle of the wafer W (fine-motion stage 438) around the Z axis is not necessary, step S3001 may be performed prior to step S1002.

The following description relates to movement of the die, serving as the second object, to be executed concurrently with or subsequently to the loading and the alignment of the wafer serving as the first object. In step S2001, the dicing frame 33 having the die D, which is singulated using a dicer, disposed on the dicing tape is loaded into the bonding device BD. Since foreign matter adhered to a bonding surface leads to a bonding defect, the dicing frame 33 is transported by using a highly sealed container in which high cleanliness is maintained. Furthermore, in order to enhance cleanliness, the die D on the dicing frame 33 may be washed inside the bonding device BD. The dicing frame 33 is roughly positioned in terms of its rotational direction and shift position by a pre-aligner (not shown) based on the external profile of the dicing frame 33.

As pretreatment, the die D may be sorted. This sorting may be performed, for example, for every type and quality (rank) of the die D. The sorting is performed based on arrangement information of the bonding target region of the wafer W, quality information of the die D, and/or the like.

In step S2002, the die D serving as the second object is picked up by the pickup head 31. In detail, the pickup head 31 and the release head 32 are positioned at the position of the die D to be picked up. This positioning is performed by using, for example, an imaging device (not shown) included in the pickup head 31 or disposed above the pickup position. Then, while the die D to be picked up is suctioned by the pickup head 31, the dicing tape is peeled from the die D by the release head 32, and the die D is held by the pickup head 31. The die D to be picked up is determined based on, for example, known-good-die (KGD) information to be transmitted online to the bonding device BD. Although only known good dies are normally picked up, a known bad die (KBD) is picked up when such a known bad die is to be bonded to the location of a defective device of the wafer W.

The pickup process may be performed based on information about the type of die D. For example, if multiple types of dies D are held on the dicing frame 33, a die D of the type to be bonded to the bonding target region of the wafer W that is to undergo a bonding process is picked up. Alternatively, the pickup process may be performed based on information about the quality of the die D. For example, a die D with a quality suitable for the bonding target region of the wafer W that is to undergo a bonding process is picked up. For example, the pickup process is performed such that a die D to be bonded to the bonding target region of a high-quality wafer W is selected to be of high quality.

In step S2003, the die D serving as the second object picked up by the pickup head 31 is transported to the bonding head 422, and the die D is held by the bonding head 422 (second holding step). When the die D is to be picked up by the pickup head 31, the semiconductor-device surface faces the pickup head 31. On the other hand, the die D is transported to the bonding head 422 such that the surface opposite the semiconductor-device surface faces the bonding head 422. The die D may be transported to the bonding head 422 directly by the pickup head 31 or via multiple die holders. Furthermore, pretreatment for bonding may be performed during the transport of the die D. Examples of the pretreatment include washing of the die, application of an adhesive in the case of adhesive-based bonding, and activation of the surface in the case of hybrid bonding. If the surface becomes inactive while the die D is being transported to the bonding head 422, the bonding surface is desirably activated by using a normal-pressure plasma activation device after the bonding head 422 holds the die D.

Accordingly, the wafer W serving as the first object and the die D serving as the second object are held by the respective holders provided therefor. Next, a bonding flow will be described. In step S1003, the position of the die D serving as the second object held by the bonding head 422 is measured (second measuring step). In detail, the wafer stage 43 is driven by the driving mechanism 435 such that the characteristic point of the die D is within the visual field of the die measuring unit 431. For example, if there are alignment marks at opposite ends of the die D, the measurement in step S1003 is performed with respect to these two points. By measuring the two alignment marks, information about the X position, Y position, and θ position of the die D can be obtained. Furthermore, by measuring three or more alignment marks, information about the rotational angle (ωX position) around the X axis and the rotational angle (ωY position) around the Y axis can also be obtained. A focus adjustment may be achieved by providing a focus adjustment mechanism within the die measuring unit 431, or by providing the bonding head 422 with a Z-axis driving mechanism and causing the Z-axis driving mechanism to drive the die D with respect to the Z axis.

Alternatively, the focus adjustment may be achieved by providing a Z-axis driving mechanism at the wafer stage 43 where the die measuring unit 431 is disposed, and driving the die measuring unit 431 with respect to the Z axis.

A scribe line having an alignment mark to be used in alignment in a semiconductor manufacturing process is removed by dicing. Therefore, the die D often does not have an alignment mark for alignment. Thus, position measurement is performed using, as a characteristic point, a terminal end of an array of pads or bumps disposed on the die D, a region having a non-periodic array and whose position can be identified, or an outer shape of the die. The controller CNT causes the die measuring unit 431 to capture an image of the die D (second imaging step), and determines the position of the characteristic point based on the relative position of the image of the characteristic point relative to the center of the output image from the die measuring unit 431.

When the position of the die D is to be measured, it is desirable to also measure the rotational amount of the die D by measuring the positions of multiple characteristic points within the die D. In order to measure the positions of multiple characteristic points, the wafer stage 43 may be driven every time the position of each characteristic point is to be measured, or the visual field of the die measuring unit 431 may be designed such that the multiple characteristic points can be observed at one time. Although the die D can be rotated by rotating the wafer stage 43 during bonding, since an interferometer has a small measurement range in the rotational direction, it is desirable to correct the rotation and re-hold the die D if the rotational amount of the die D is large. If the die D is re-held, it is necessary to measure the position of the die D again. Alternatively, the bonding head 422 performs correction by ωZ driving. In the process of this operation, the surface position of the bonding surface of the die D serving as the second object may be measured during an autofocus operation performed in position measurement of the die, or by using a second height measuring device (not shown). Since the thickness of the die D varies, it is advantageous to measure the surface position of the die D in order to manage the gap between the wafer W and the die D with high accuracy during a bonding operation. Furthermore, multiple height positions of the die D may be measured, and the orientation of the die D or the wafer W may be adjusted during bonding by using a tilting mechanism (not shown). Such a tilting mechanism is incorporated in the wafer stage 43, the wafer chuck 432, or the bonding head 422.

In step S1004, the wafer stage 43 is driven by the driving mechanism 435 such that the die D serving as the second object is positioned to a bonding target location selected from multiple bonding target locations of the wafer W serving as the first object. In this case, the controller CNT controls the driving mechanism 435 such that the position of the wafer stage 43 is feedback-controlled based on a measurement result obtained by the interferometer 434. Moreover, in this case, the controller CNT determines the relative movement amount of the bonding head 422 and the wafer stage 43 based on the position and rotational amount of the wafer W and the position and rotational amount of the die D respectively measured in step S1002 and step S1003 and also based on the offset amount.

In this case, since the coarse-motion stage 437 and the fine-motion stage 438 are in contact with each other as a result of step S3001, the position of the fine-motion stage 438 alone is not adjustable. The fine-motion stage 438 can be positionally adjusted by adjusting the position of the coarse-motion stage 437. In the case of this embodiment, since the coarse-motion stage 437 is movable in the X-axis direction and the Y-axis direction, the position of the fine-motion stage 438 is adjustable with respect to two axes (X and Y axes) in the case of the first control. For the four remaining axes (Z, ωX, ωY, and ωZ), an adjustment is performed at the bonding head 422 side, so that the bonding accuracy can be maintained. Specifically, in the first control, the number of driving shafts that drive the bonding head 422 is greater than the number of driving shafts that drive the fine-motion stage 438. In other words, in the first control, the number of driving directions in which the bonding head 422 is drivable is greater than the number of driving directions in which the fine-motion stage 438 is drivable.

In step S1005, the die D serving as the second object is bonded to the selected bonding target location of the wafer W serving as the first object (bonding step).

The operation for bonding in step S1005 may involve raising or lowering the bonding head 422 or raising or lowering the wafer stage 43 or the wafer chuck 432. In other words, the driving mechanism may perform driving to change the relative position (distance) between the die D held by the bonding head 422 and the wafer W held by the wafer chuck 432.

In the operation of the positioning mechanism for changing this relative position, feedback control using a measurement result of a measurement mechanism, such as an interferometer, is performed. In order to control the gap between the first object and the second object with high accuracy, a linear encoder may be provided for measuring the position of the raising/lowering driving mechanism in the Z-axis direction. When the first object and the second object come into contact with each other, the wafer stage feedback-controlled by using the interferometer is restrained. Therefore, the control method may be changed before and after the contact, for example, by stopping the feedback control. The bonding involves relatively moving the wafer W and the die D by acceleration driving or constant-speed driving of the driving mechanism to bring the wafer W and the die D closer to each other, and then relatively moving the wafer W and the die D further by constant-speed driving after they have approached each other, thereby bringing the wafer W and the die D into contact with each other. Then, the driving mechanism performs driving to further reduce the relative distance between the bonding head 422 and the wafer chuck 432, and a load for bonding the wafer W and the die D to each other is applied so that the wafer W and the die D are bonded to each other. Subsequently, a holding force applied by the bonding head 422 for holding the die D is reduced so that the bonding head 422 no longer holds the die D, and the driving mechanism performs driving to increase the relative distance between the bonding head 422 and the wafer chuck 432.

In the bonding, multiple types of dies D may be bonded to a single wafer W, different dies D may be bonded to respective bonding target regions on the wafer W, and/or the number of dies D to be bonded to each bonding target region on the wafer W may be varied.

In step S1006, the controller CNT determines whether or not the bonding process for bonding the die D serving as the second object to the wafer W serving as the first object is completed. This is equivalent to determining whether or not the bonding is completed for all dies D to be bonded to the wafer W. For example, when dies D are to be bonded to two bonding target regions on the wafer W, if the bonding process is completed for one of the bonding target regions but is not completed for the other bonding target region, it is determined that the bonding process is not completed in step S1006. Alternatively, when a die D is bonded to one bonding target region of the wafer W and another die D is to be subsequently bonded onto the already-bonded die D, if the bonding process for bonding the second die D to the one bonding target region is not completed, it is determined in step S1006 that the bonding process is not completed. If the bonding process is not completed, the procedure returns to the die pickup process in step S2002.

In the example in Fig. 7, the above-described determination is performed after the bonding operation in step S1005, and the die D is picked up in step S2002. Alternatively, the die pickup process in step S2002 may be performed concurrently in a period from the die alignment in step S1003 to the bonding operation in step S1005. In this bonding method, the steps in Fig. 7 (i.e., step S1001 to step S1007, step S2001 to step S2003, and step S3001) are performed by the controller CNT in accordance with a program stored therein.

When the bonding of the dies D to all of the multiple bonding target locations of the wafer W is completed, the wafer W is unloaded from the bonding device BD in step S1007. The wafer W may be returned to the FOUP or may be returned to a different container. However, since the thickness of the wafer W has changed as a result of the bonding and the gap between wafers needs to be widened as compared with the wafer before the bonding, the wafer W is normally returned to the different container.

Next, a method for managing an offset amount to be reflected in the driving of the bonding position in step S1004 with respect to the position of the die D measured by using the die measuring unit 431 will be described. This process is controlled by the controller CNT.

The wafer W has an alignment mark used for aligning the wafer W and a mark used for measuring bonding misalignment, to be described below. The position of the alignment mark on the wafer W is measured by using the wafer measuring unit 421, and based on this result, the installation position and the rotational amount of the wafer W are calculated. During this operation, the surface position of the bonding surface of the wafer W may be measured by using the first height measuring device (not shown). Since the thickness of the wafer W varies, it is advantageous to measure the surface position of the wafer W in order to manage the gap between the wafer W and the die D with high accuracy during a bonding operation.

The die D has an alignment mark used for measuring the position of the die D and a mark used for measuring bonding misalignment. The position and the rotational amount of the die D held by the bonding head 422 are measured by using the die measuring unit 431. During this operation, the surface position of the bonding surface of the die D may be measured by using the second height measuring device (not shown). Since the thickness of the die D varies, it is advantageous to measure the surface position of the die D in order to manage the gap between the wafer W and the die D with high accuracy during a bonding operation. Furthermore, multiple height positions of the die D may be measured, and the relative orientation (relative tilt) between the die D and the wafer W may be adjusted during bonding by using the tilting mechanism (not shown). Such a tilting mechanism is incorporated in the wafer stage 43, the wafer chuck 432, or the bonding head 422.

Subsequently, the wafer stage 43 is driven by the driving mechanism 435 such that the die D is positioned to the bonding target location selected from the multiple bonding target locations of the wafer W. In this case, the controller CNT controls the driving mechanism 435 such that the position of the wafer stage 43 is feedback-controlled based on a measurement result obtained by the interferometer 434. Moreover, in this case, the controller CNT determines a target position for the wafer stage 43 based on the measured position and rotational amount of the wafer W, the measured position and rotational amount of the die D, and the offset amount. Then, the die D is bonded to the selected bonding target location of the wafer W.

In this case, the bonding position is measured for managing the offset amount to be reflected in the driving of the bonding position. In detail, the wafer stage 43 is driven by the driving mechanism 435 such that the mark used for measuring bonding misalignment is within the visual field of the wafer measuring unit 421, and a bonding misalignment amount between the wafer W and the die D is measured by using the wafer measuring unit 421. Examples of the mark used for measuring bonding misalignment include a 30-µm-width rectangular frame at the wafer side and a 60-µm-width rectangular frame at the glass die side. By bonding these two frames together in a stacked fashion, bonding misalignment can be measured from the amount of misalignment between the two frames. The mark used for measuring bonding misalignment may be circular instead of being rectangular. The mark at the wafer side may be an outer mark and the mark at the die side may be an inner mark. By measuring the two different marks, the amount of misalignment may be detected from the distance therebetween. In order to determine bonding misalignment, an amount of misalignment may be measured for each of multiple marks within the die D. By measuring each of the multiple marks within the die D, a rotational error in bonding can also be measured, and a measurement error can be reduced by statistical processing, whereby bonding misalignment can be measured with high accuracy.

The controller CNT calculates the offset amount based on a positional deviation calculated by using the die measuring unit 431. The calculated offset amount includes, for example, shift amounts in the X-axis direction and the Y-axis direction and a rotational amount around the Z axis. In this case, the die D may be bonded to each of the multiple bonding target locations of the wafer W, and the offset amount may be calculated for each of the multiple bonding target locations. Alternatively, the die D may be bonded to each of the multiple bonding target locations of the wafer W, and an ultimate offset amount may be calculated by averaging out the offset amounts calculated for the respective bonding target locations. The controller CNT reflects the calculated offset amount and controls the driving of the driving mechanism for a relative positional adjustment between the die D and the wafer W in bonding.

Although the above description relates to an example where the wafer stage 43 moves in the XY plane, the bonding head 422 may move in the XY plane, or the wafer stage 43 and the bonding head 422 may both move in the XY plane. If the bonding head 422 is configured to move, it is preferable that the bonding head 422 includes a driving mechanism and that the bonding unit 4 is provided with a measurement mechanism (i.e., an interferometer or an encoder) for measuring the position of the bonding head 422.

When the bonding load is applied during the first control, the relative position between the fine-motion stage 438 and the coarse-motion stage 437 may sometimes be deviated depending on the magnitude of the bonding load or the direction in which the bonding load is applied. The relative position between the fine-motion stage 438 and the coarse-motion stage 437 may also become deviated when multiple bonding heads perform the bonding operation at different timings. In order to reduce such a deviation of the relative position, a fixing mechanism that fixes the relative position between the fine-motion stage 438 and the coarse-motion stage 437 may be further provided.

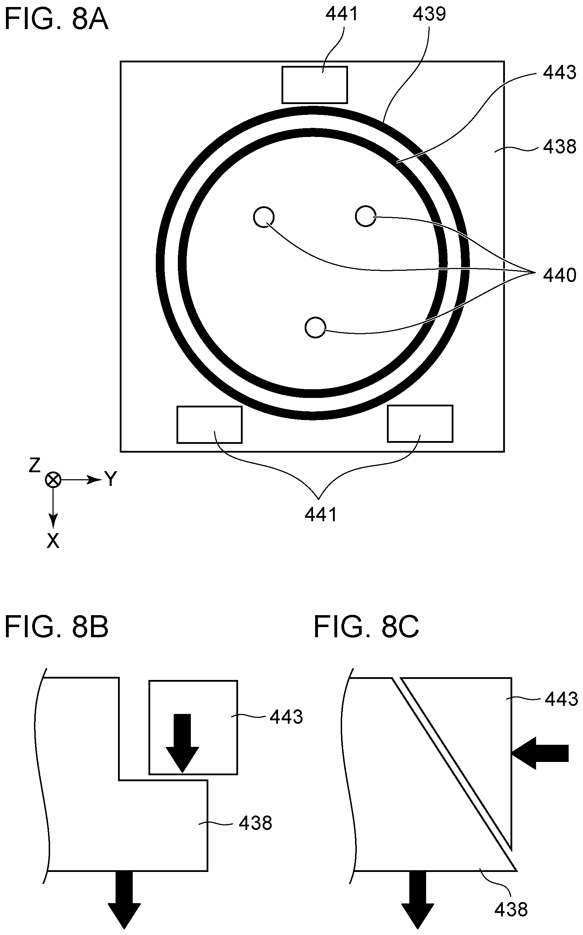

Fig. 8A, Fig. 8B, and Fig. 8C schematically illustrate a fixing mechanism of the fine-motion stage 438. Fig. 8A schematically illustrates the fine-motion stage 438 and corresponds to a case where the fine-motion stage 438 is viewed from the -Z side between the fine-motion stage 438 and the coarse-motion stage 437. The fine-motion stage 438 further includes a fixing mechanism 443. Alternatively, the coarse-motion stage 437 may be provided with the fixing mechanism 443, or at least one of the coarse-motion stage 437 and the fine-motion stage 438 may be provided with the fixing mechanism 443. For example, the fixing mechanism 443 may be a mechanism that exhausts gas from the space between the coarse-motion stage 437 and the fine-motion stage 438 so as to fix the relative position between the coarse-motion stage 437 and the fine-motion stage 438. Alternatively, as shown in Fig. 8B, the fixing mechanism 443 may be a mechanism that causes an actuator to apply a force in the -Z direction to the fine-motion stage 438 so as to fix the relative position between the coarse-motion stage 437 and the fine-motion stage 438. As another alternative, as shown in Fig. 8C, the fixing mechanism 443 may be a mechanism that causes an actuator to apply a force acting in a direction parallel to the XY plane to a tapered section provided at the fine-motion stage 438. In this case, the tapered shape of the fine-motion stage 438 causes the force acting in the direction parallel to the XY plane to be converted into a force acting in the Z-axis direction (-Z direction), thereby fixing the relative position between the coarse-motion stage 437 and the fine-motion stage 438. As a further alternative, the fixing mechanism 443 may be an electromagnetic actuator identical to or different from each adjustment mechanism 441. This electromagnetic actuator applies a force that draws the fine-motion stage 438 toward the coarse-motion stage 437. As another alternative, the fixing mechanism 443 may be a mechanism that clamps and fixes a specific portion of the fine-motion stage 438 from the +Z side and the -Z side.

According to this embodiment, the position of the fine-motion stage 438 can be stabilized in a bonding operation, so that the bonding accuracy can be improved.

### Second Embodiment

This embodiment is different from the first embodiment in terms of the criterion used for switching between the first control and the second control.

In a state (second control) where the adjustment mechanisms 441 are adjusting the distance between the coarse-motion stage 437 and the fine-motion stage 438 so as not to bring them into contact with each other, the rotational angle (ωX position, ωY position, ωZ position) of the fine-motion stage 438 can be adjusted. On the other hand, when the coarse-motion stage 437 and the fine-motion stage 438 are in contact with each other (first control), the position of the fine-motion stage 438 during a bonding operation can be stabilized. In this embodiment, the first control and the second control are switched therebetween based on the bonding load or the bonding position.

In detail, if the bonding load is greater than a predetermined threshold value (or greater than or equal to the threshold value), there is a possibility that the position of the fine-motion stage 438 is not stable during the bonding operation. Thus, the controller CNT performs the first control for bringing the coarse-motion stage 437 and the fine-motion stage 438 into contact with each other. If the bonding load is less than the predetermined threshold value, since the position of the fine-motion stage 438 is stable even if the coarse-motion stage 437 and the fine-motion stage 438 are not brought into contact with each other during the bonding operation, the controller CNT performs the second control. If the bonding target location (bonding target region) on the wafer W is an end (or near an end) of the wafer W, there is a possibility that the position of the fine-motion stage 438 is not stable during the bonding operation. Thus, the controller CNT performs the first control for bringing the coarse-motion stage 437 and the fine-motion stage 438 into contact with each other. If the bonding target location (bonding target region) on the wafer W is the central region (or near the central region) of the wafer W, since the position of the fine-motion stage 438 is stable even if the coarse-motion stage 437 and the fine-motion stage 438 are not brought into contact with each other during the bonding operation, the controller CNT performs the second control. In other words, if the position of the fine-motion stage 438 is not stable, the first control for bringing the coarse-motion stage 437 and the fine-motion stage 438 into contact with each other is performed. If the position of the fine-motion stage 438 is stable, the second control for not bringing the coarse-motion stage 437 and the fine-motion stage 438 into each other is performed. By switching between the first control and the second control in this manner, the second control is performed when the position of the fine-motion stage 438 is stable, and the position of the fine-motion stage 438 is adjustable with respect to six axes. By adjusting the position of the fine-motion stage 438 with respect to six axes, the bonding can be performed with higher accuracy. The six-axis positional adjustment performed on the wafer W (fine-motion stage 438) includes an adjustment of the position in the X-axis direction, an adjustment of the position in the Y-axis direction, an adjustment of the position in the Z-axis direction, an adjustment of the rotational angle (ωX) around the X axis, an adjustment of the rotational angle (ωY) around the Y axis, and an adjustment of the rotational angle (ωZ) around the Z axis.

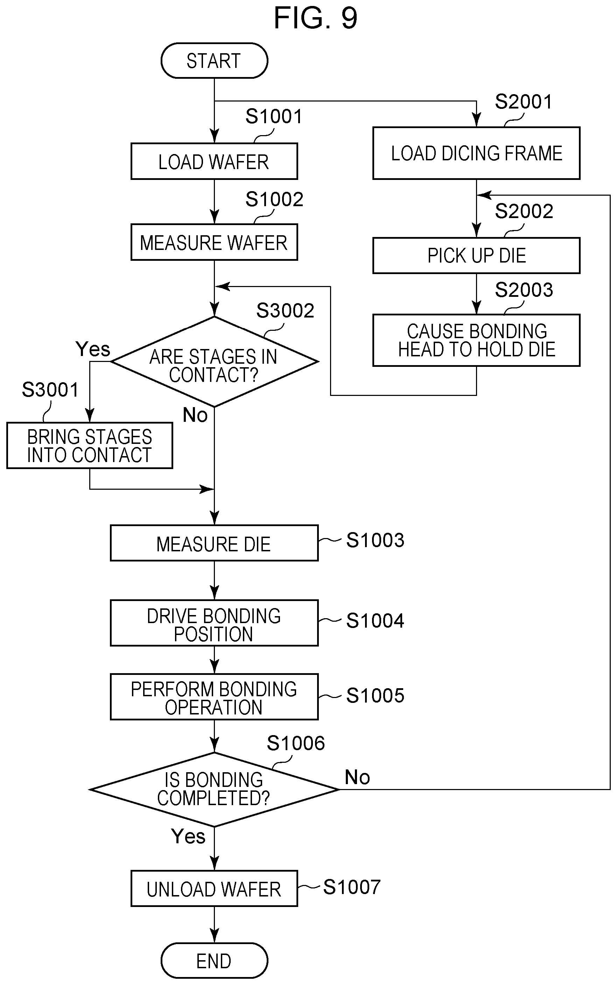

Fig. 9 illustrates a flowchart of a bonding method according to this embodiment. Descriptions of sections similar to those in Fig. 7 will be omitted. In the flowchart in Fig. 9, step S3002 is performed after step S1002 and step S2003. In step S3002, the controller CNT determines whether or not to bring the coarse-motion stage 437 and the fine-motion stage 438 into contact with each other based on at least one of information about the bonding load and information about the bonding position (i.e., the position of the bonding target region). In other words, the controller CNT selects one of the first control and the second control based on at least one of the information about the bonding load and the information about the bonding position. This selection of control may be performed based on the information about the bonding load alone, may be performed based on the information about the bonding position alone, or may be performed based on both the information about the bonding load and the information about the bonding position. If the selection of control is to be performed based on both the information about the bonding load and the information about the bonding position, the first control may be performed when either of the two satisfies a predetermined condition (e.g., when the bonding load is greater than or equal to a threshold value or when the bonding position corresponds to an end). Alternatively, the selection of control may be performed based on a predetermined table, a predetermined equation, or the like, or based on machine learning or the like.

If the controller CNT determines in step S3002 to bring the coarse-motion stage 437 and the fine-motion stage 438 into contact with each other (i.e., if the controller CNT selects the first control), the controller CNT performs step S3001. Since step S3001 is identical to that in the first embodiment, a description thereof will be omitted. After step S3001, the procedure proceeds to step S1003.

If the controller CNT determines in step S3002 not to bring the coarse-motion stage 437 and the fine-motion stage 438 into contact with each other (i.e., if the controller CNT selects the second control), the procedure proceeds to step S1003.

If the second control is selected, the position of the fine-motion stage 438 is adjustable with respect to six axes in step S1004 or step S1005. Although step S3002 is performed for each die D in the example in Fig. 9, if the bonding load is uniform among the dies D and a difference in bonding positions has a small effect on the stability of the position of the fine-motion stage 438, the determination in step S3002 may be performed only on the first die D to be bonded. In this bonding method, the steps in Fig. 9 (i.e., step S1001 to step S1007, step S2001 to step S2003, step s3001, and step S3002) are performed by the controller CNT in accordance with a program stored therein.

### Third Embodiment

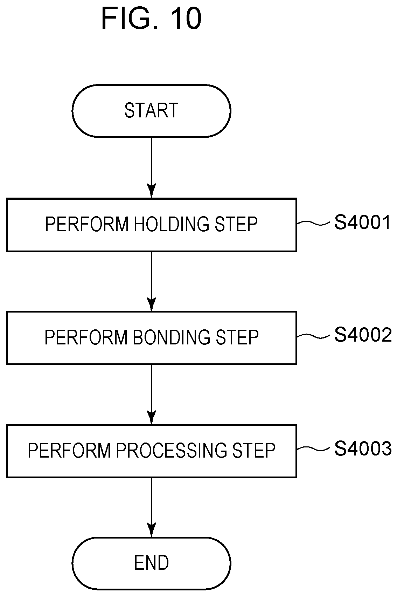

Fig. 10 illustrates a flowchart of a manufacturing method for an article. First, a holding step (S4001) for causing the fine-motion stage (first stage) 438 to hold the wafer (first object) W is performed. Subsequently, a bonding step (S4002) for bonding the die (second object) D to the wafer (first object) W is performed. Then, a processing step (S4003) for processing the wafer W having the die D bonded thereto in the bonding step is performed.

The bonding step includes performing one of the first control for bringing the fine-motion stage 438 and the coarse-motion stage 437 that supports the fine-motion stage 438 into contact with each other and the second control for not bringing the fine-motion stage 438 and the coarse-motion stage 437 into contact with each other. The coarse-motion stage 437 serves as a second stage.

The first control is performed when the wafer W and the die D are in contact with each other. Alternatively, the control to be performed in the bonding step is determined based on at least one of the bonding load applied when the die D and the wafer W are bonded to each other and the position of the bonding target region of the wafer W.

Examples of the article to be manufactured in accordance with this manufacturing method include a semiconductor integrated-circuit (IC) element, a liquid crystal display element, a color filter, a microelectromechanical system (MEMS), a light emitting diode (LED), a sensor, and an optical device. According to this manufacturing method, an article of higher quality than in the related art can be manufactured.

The present disclosure is not limited to the above embodiments, and various modifications and alterations are possible so long as they do not depart from the spirit and scope of the disclosure. Accordingly, claims are appended in order to disclose the scope of the disclosure to the public.

### Other Embodiments

Embodiments of the present disclosure can also be realized by a computer of a system or apparatus that reads out and executes computer executable instructions (e.g., one or more programs) recorded on a storage medium (which may also be referred to more fully as a 'non-transitory computer-readable storage medium') to perform the functions of one or more of the above-described embodiments and/or that includes one or more circuits (e.g., application specific integrated circuit (ASIC)) for performing the functions of one or more of the above-described embodiments, and by a method performed by the computer of the system or apparatus by, for example, reading out and executing the computer executable instructions from the storage medium to perform the functions of one or more of the above-described embodiments and/or controlling the one or more circuits to perform the functions of one or more of the above-described embodiments. The computer may comprise one or more processors (e.g., central processing unit (CPU), micro processing unit (MPU)) and may include a network of separate computers or separate processors to read out and execute the computer executable instructions. The computer executable instructions may be provided to the computer, for example, from a network or the storage medium. The storage medium may include, for example, one or more of a hard disk, a random-access memory (RAM), a read only memory (ROM), a storage of distributed computing systems, an optical disk (such as a compact disc (CD), digital versatile disc (DVD), or Blu-ray Disc (BD)^{TM}), a flash memory device, a memory card, and the like.

While the present disclosure has been described with reference to embodiments, it is to be understood that the present disclosure is not limited to the disclosed embodiments. The scope of the following claims is to be accorded the broadest interpretation so as to encompass all such modifications and equivalent structures and functions.

Various embodiments have been described in detail above but it will be understood that the present disclosure is not limited to these embodiments and encompasses all modifications, variants, alternatives and equivalents falling within the scope of the appended claims.

## Claims

1. A bonding device (BD) for bonding a second object (D) to a first object (W), the bonding device (BD) comprising:
a first stage (438) configured to hold the first object (W);
a second stage (437) configured to support the first stage (438); and
a controller (CNT) capable of switching between first control and second control, the first control including performing control to bring the first stage (438) and the second stage (437) into contact with each other, the second control including performing control such that the first stage (438) and the second stage (437) face each other via a gap,
wherein the controller is configured to perform the first control when the first object (W) and the second object (D) are in contact with each other.

2. The bonding device (BD) according to claim 1,
wherein the controller (CNT) is configured to control an adjustment mechanism (441) to control a distance between the first stage (438) and the second stage (437).

3. The bonding device (BD) according to claim 2,
wherein the adjustment mechanism (441) includes at least one of an electromagnetic actuator, an air bearing mechanism, and a mechanism whose volume varies in response to a fluctuation in internal air pressure.

4. The bonding device (BD) according to claim 3,
wherein the adjustment mechanism (441) includes an electromagnetic actuator, and
wherein the controller (CNT) is configured to perform control to stop supplying an electric current to the electromagnetic actuator in the first control.

5. The bonding device (BD) according to any one of claims 2 to 4,
wherein the adjustment mechanism (441) is disposed at three or more different locations.

6. The bonding device (BD) according to any one of the preceding claims,
wherein, in the second control, positions of the first stage (438) and the second stage (437) are controlled such that the gap between the first stage and the second stage is between 0.1 mm and 10 mm.

7. The bonding device (BD) according to any one of the preceding claims, further comprising:
a head (422) configured to hold the second object (D),
wherein, in the first control, a number of driving directions in which the head is drivable is greater than a number of driving directions in which the first stage (438) is drivable.

8. The bonding device (BD) according to any one of the preceding claims, further comprising:
a fixing mechanism (443) configured to fix a relative position between the first stage (438) and the second stage (437).

9. The bonding device (BD) according to claim 8,
wherein the fixing mechanism (443) includes at least one of a mechanism that exhausts gas from between the first stage (438) and the second stage (437), an electromagnetic actuator, and an actuator that applies a force to the first stage (438).

10. The bonding device (BD) according to any one of the preceding claims,
wherein the controller (CNT) is configured to perform control to measure a position of the first object (W) when performing the second control.

11. The bonding device (BD) according to any one of the preceding claims,
wherein the controller (CNT) is configured to perform the first control after adjusting a rotational angle of the first object (W) around an axis orthogonal to a surface having a bonding target region of the first object (W).

12. The bonding device (BD) according to any one of the preceding claims,
wherein if a relative position between the first stage (438) and the second stage (437) becomes deviated when the first stage (438) and the second stage (437) are brought into contact with each other, the controller (CNT) is configured to perform the second control and then perform the first control again.

13. A bonding method for bonding a second object (D) to a first object (W), the bonding method comprising:
holding the first object (W) on a first stage (438); and
bonding the second object (D) to the first object (W),
performing first control and second control, the first control including performing control to bring the first stage (438) and a second stage (437) that supports the first stage (438) into contact with each other, and the second control including performing control such that the first stage (438) and the second stage (437) face each other via a gap,
wherein the first control is performed when the first object (W) and the second object (D) are in contact with each other.

14. A non-transitory computer-readable storage medium storing a program for causing a computer to execute the bonding method according to claim 13.

15. A manufacturing method for an article, the manufacturing method comprising bonding a second object (D) to a first object (W) by the bonding method according to claim 13.
